(19) Europäisches Patentamt
European Patent Office
Office européen des brevets

(11) **EP 1 630 820 B1**

(12) **FASCICULE DE BREVET EUROPEEN**

(45) Date de publication et mention
de la délivrance du brevet:
**11.04.2007 Bulletin 2007/15**

(51) Int Cl.:
***G11C 16/34*** *(2006.01)*

(21) Numéro de dépôt: **05015927.6**

(22) Date de dépôt: **22.07.2005**

(54) **Procédé de programmation de cellules mémoire incluant une détection des dégradations de transconductance**

Speicherzellenprogrammierverfahren mit Detektion von Transkonduktanzdegradierung

Memory cell programming method with detection of transconductance degradation

(84) Etats contractants désignés:
**DE FR GB IT**

(30) Priorité: **31.08.2004 FR 0409215**

(43) Date de publication de la demande:
**01.03.2006 Bulletin 2006/09**

(73) Titulaire: **STMicroelectronics SA**
**92120 Montrouge (FR)**

(72) Inventeur: **Devin, Jean**
**13100 Le Tholonet (FR)**

(74) Mandataire: **Marchand, André**
**OMNIPAT,**
**24 Place des Martyrs de la Résistance**
**13100 Aix-en-Provence (FR)**

(56) Documents cités:
**US-A- 5 532 962        US-A1- 2003 142 546**
**US-A1- 2004 017 722     US-B1- 6 195 290**

**Description**

La présente invention concerne les mémoires effaçables et programmables électriquement intégrées sur microplaquette de silicium, et plus particulièrement la programmation de cellules mémoire dans de telles mémoires.

Les mémoires effaçables et programmables électriquement, notamment les mémoires Flash, sont généralement conçues pour exécuter une opération de programmation en plusieurs cycles. Chaque cycle comprend, pour chaque cellule mémoire à programmer, une étape de vérification de l'état de la cellule mémoire et une étape de programmation de la cellule mémoire, l'étape de programmation n'étant effectué que si la cellule mémoire est vue comme n'étant pas dans l'état programmé au cours de l'étape de vérification.

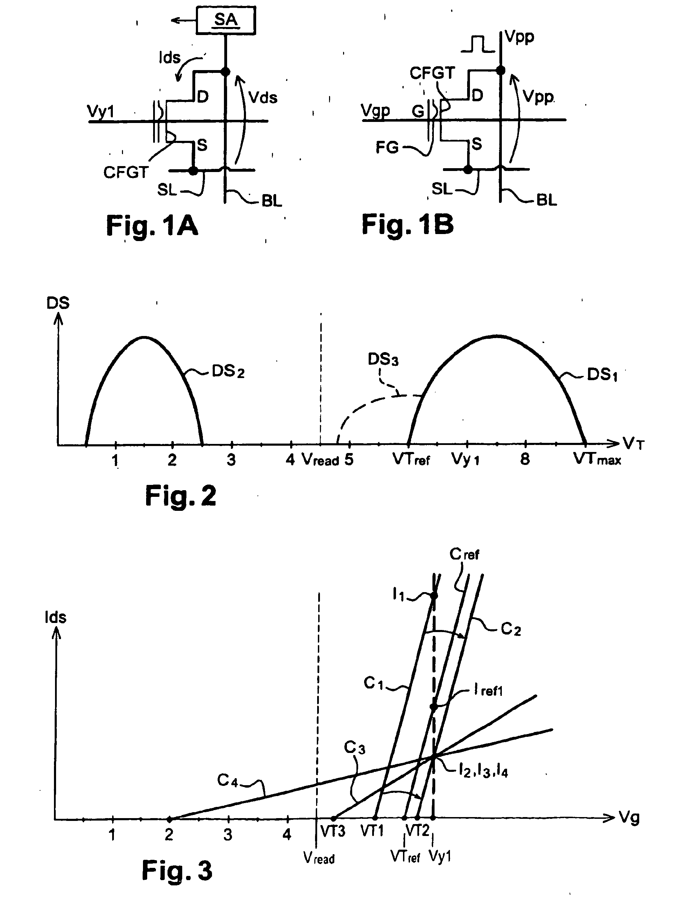

Un exemple de mise en oeuvre de l'étape de vérification est illustré sur la figure 1A. La figure 1A représente une cellule mémoire de type Flash formée par un transistor à grille flottante CFGT de type NMOS. La cellule mémoire est agencée dans un plan mémoire (non représenté) comprenant une pluralité de cellules mémoire agencées en lignes et en colonnes, de sorte que le drain D du transistor CFGT est relié à une ligne de bit BL, sa source S est reliée à une ligne de source SL, et sa grille de contrôle G est reliée à une ligne de mot WL. L'étape de vérification est assurée par un amplificateur de lecture SA ("sense amplifier") relié à la ligne de bit BL. L'amplificateur SA applique une tension drain-source déterminée au transistor CFGT, généralement une tension de l'ordre de 1V, tandis qu'une tension de lecture Vy1 est appliquée sur la grille de contrôle G. L'amplificateur SA compare le courant drain-source Ids traversant le transistor à un courant de référence Iref1. Si le courant Ids est inférieur à Iref1, la cellule mémoire est considérée comme étant dans l'état programmé. Si le courant Ids est supérieur à Iref1, la cellule mémoire est considérée comme étant encore dans l'état effacé.

La tension Vy1 est supérieure à une tension de référence VTref qui représente la tension de seuil minimale visée pour qu'un transistor à grille flottante soit considéré comme étant dans l'état programmé. Le courant de référence Iref1 correspond au courant traversant un transistor à grille flottante présentant la tension de seuil VTref, lorsque celui-ci reçoit la tension Vy1 sur sa grille de contrôle.

Un exemple de mise en oeuvre de l'étape de programmation est illustré sur la figure 1B. Une impulsion d'une tension de programmation Vpp, généralement de l'ordre de 5 à 10V, est appliquée entre le drain et la source du transistor CFGT, tandis qu'une tension Vgp est appliquée sur sa grille de contrôle. Un courant traverse le canal du transistor CFGT et des charges électriques négatives sont injectées et piégées dans la grille flottante (FG) du transistor. La tension de seuil VT du transistor augmente d'un incrément déterminé. Après une ou plusieurs impulsions de tension de programmation Vpp, précédées chacune d'une étape de vérification, la tension de seuil VT du transistor atteint en principe une valeur au moins égale à la tension de référence VTref.

Ainsi, la distribution statistique des tensions de seuil d'une pluralité de cellules mémoire au sein d'un même plan mémoire doit, en principe, être conforme à une courbe DS1 représentée en figure 2, et les tensions de seuil doivent se trouver comprises entre la tension VTref, par exemple de l'ordre de 6V, et un maximum VTmax, par exemple de l'ordre de 9V, la tension de Vy1 étant par exemple de l'ordre 6, 5V. La figure 2 représente également une courbe DS2 illustrant la distribution statistique des tensions de seuil de cellules mémoire dans l'état effacé, qui est comprise par exemple entre 0,5V et 2,5V. Une tension de lecture Vread, représentant la tension de grille appliquée aux cellules mémoire lors d'une lecture normale du plan mémoire, est également représentée. La tension Vread est différente de la tension de lecture-vérification Vy1 et est comprise entre les deux courbes de distribution DS1, DS2, par exemple au voisinage des 4,5V.

La présente invention vise à résoudre un problème qui, originellement, a été détecté par la découverte d'une anomalie dans la distribution des tensions de seuil de cellules mémoire dans l'état programmé. Une telle anomalie est représentée sur la figure 2 par une courbe DS3 qui forme une sorte d'excroissance parasite s'étendant à gauche de la courbe DS1. Ainsi, contre toute attente, certaines cellules mémoire programmées présentent des tensions de seuil inférieures à VTref alors qu'elles sont vérifiées pendant leur programmation et qu'elles présentent un courant Ids supérieur au courant de référence Iref1.

Les constatations, explications et hypothèses divulguées ici font partie intégrante de la présente invention.

Selon la présente invention, une telle erreur dans la distribution statistique des tensions de seuil est imputable à une dégradation de la courbe de transconductance Ids=f(Vgs) des cellules mémoire, apparaissant lorsque celles-ci subissent un nombre important de cycles de stress électrique. Le phénomène de stress électrique est en soi bien connu de l'homme de l'art. Il est particulièrement problématique dans les mémoires Flash effaçables par pages, car les cellules mémoire peuvent recevoir un grand nombre de fois la tension de programmation Vpp sur leur drain pendant la programmation de cellules mémoire voisines appartenant à la même ligne de bit, sans jamais être effacées (du fait que l'effacement est appliqué sélectivement à des pages de la mémoire au lieu d'être appliqué à tout un secteur mémoire). L'effet premier du stress électrique est que les cellules mémoire dans l'état programmé perdent des charges électriques, de sorte que leur tension de seuil diminue progressivement. On sait résoudre ce problème en prévoyant un rafraîchissement régulier des cellules mémoire. Toutefois, un tel rafraîchissement ne permet aucunement de résoudre le problème exposé ci-dessus, qui est lié à une accélération du vieillissement des cellules mémoire en raison du stress électrique subi.

La dégradation de la courbe de transconductance et ses conséquences sur la lecture-vérification d'une cellule mémoire seront mieux compris en se référant à la figure 3. Sur la figure 3 sont représentées des courbes de transconductance C1, C2, Cref, C4, C5 de transistors à grille flottante. Ces diverses courbes illustrent le fonctionnement des transistors à grille flottante en régime saturé (Vgs<Vds, zone de fonctionnement ohmique) et définissent le courant drain-source Ids (axe vertical) traversant les transistors en fonction de la tension grille-source Vgs (axe horizontal) qui leur est appliquée. Les courbes de transconductance sont représentées ici sous une forme simplifiée suffisante pour la compréhension de la présente invention, à savoir sous forme de fonction affine du type "Y=aX+b", avec "Y" le courant Ids, "X" la tension Vgs, "a" la pente de transconductance et "b" la tension à l'origine, "b" représentant la tension de seuil du transistor à grille flottante considéré.

La courbe Cref est la courbe de transconductance d'une cellule mémoire de référence ayant une tension de seuil égale à VTref, par exemple 6,5V. Le courant Ids traversant la cellule de référence lorsqu'elle reçoit sur sa grille la tension de lecture-vérification Vy1, forme le courant de référence Iref1.

La courbe C1 est la courbe de transconductance non dégradée d'une cellule mémoire en cours de programmation dont la tension de seuil présente une valeur VT1 (pied de la courbe C1) inférieure à VTref et supérieure à Vread. Lorsque la tension de lecture-vérification Vy1 lui est appliquée, la cellule est traversée par un courant drain-source I1 supérieur à Iref1 et est donc considérée comme n'étant pas programmée, malgré le fait que la tension de seuil de cette cellule soit supérieure à Vread et que la cellule mémoire serait lue comme étant programmée au cours d'une lecture normale faite avec la tension Vread.

La courbe C2 est la courbe de transconductance de la même cellule mémoire lorsque le processus de programmation est terminé, c'est-à-dire après que la cellule mémoire a reçu une ou plusieurs impulsions de tension de programmation supplémentaires. Sa tension de seuil présente alors une valeur VT2 supérieure à VTref et, lorsque la tension de lecture-vérification Vy1 lui est appliquée, son courant drain-source présente une valeur I2 inférieure à Iref1.

La courbe C3 est la courbe de transconductance dégradée d'une cellule mémoire ayant subi un grand nombre de cycles de stress électrique. Cette cellule mémoire présente une tension de seuil VT3 inférieure à VTref et sensiblement supérieure à Vread, et est supposée être en cours de programmation. La dégradation de sa transconductance se traduit par un affaiblissement de la pente "a" de la courbe C3. Lorsque la cellule mémoire est lue avec la tension Vy1 au cours de l'étape de lecture-vérification, elle est traversée par un courant I3 se situant en dessous du courant Iref1 et égal, dans cet exemple, au courant I2. Ainsi, la cellule mémoire est considérée par l'amplificateur de lecture comme étant dans l'état programmé et les impulsions de tension de programmation cessent de lui être appliquées, alors que sa tension de seuil n'a pas atteint le seuil visé VTref.

Cet exemple de courbe de transconductance dégradée ne conduit pas encore à une erreur de lecture dans le mode de lecture normal, puisque la tension de seuil de la cellule mémoire se situe au-dessus de la tension Vread. Toutefois, les prochaines générations de mémoires Flash comporteront des transistors à grille flottante ayant une longueur de canal encore plus faible que celle des générations actuelles (de l'ordre du dixième de micromètre) et seront encore plus sensibles au stress électrique. Ainsi, l'erreur de distribution DS3 pourrait s'étendre jusqu'à la tension Vread voire même au-delà, de sorte qu'il ne serait plus possible de distinguer une cellule mémoire programmée d'une cellule mémoire effacée (ceci entraînant une erreur de lecture ou corruption de données). On peut même craindre qu'une cellule mémoire puisse présenter une dégradation de transconductance telle qu'elle sera lue comme programmée, bien qu'étant dans l'état effacé, dès la première étape de lecture-vérification du processus de programmation, et avant même d'avoir reçu la première impulsion de tension de programmation Vpp. Ce risque est illustré par la courbe de transconductance C4, qui présente une tension de seuil de 2V correspondant à une cellule mémoire effacée mais dont la pente est suffisamment faible pour qu'elle présente, à la tension Vy1, un courant I4 de cellule mémoire programmée (égal dans cet exemple au courant I2)

Un autre procédé de vérification de programmation est décrit dans US 2003/142546.

La présente invention vise à pallier cet inconvénient.

Plus particulièrement, la présente invention vise un procédé de programmation de cellules mémoire qui puisse détecter la présence de cellules mémoire ayant une transconductance dégradée et qui garantisse que de telles cellules mémoire reçoivent un nombre d'impulsions de tension de programmation suffisant pour que leur tension de seuil soit portée à une valeur supérieure à la tension de lecture Vread du processus de lecture normal.

Pour atteindre cet objectif, la présente invention se fonde sur la constatation qu'une cellule mémoire qui n'est pas complètement programmée, c'est-à-dire qui présente une tension de seuil inférieure à la tension référence VTref, présente un courant drain-source non nul quand elle est lue avec une tension de lecture inférieure au seuil VTref. Ainsi, une idée simple mais non moins inventive de la présente invention est de prévoir, en sus de la lecture-vérification faite avec une tension Vy1 supérieure au seuil VTref, une lecture-vérification complémentaire faite avec une tension de lecture Vy2 inférieure à VTref. Si la cellule mémoire est dans l'état passant au cours de la seconde lecture, cela signifie que la tension de seuil de la cellule mémoire est inférieure à VTref et que la cellule doit encore recevoir des impulsions de tension de programmation.

Plus particulièrement, la présente invention prévoit un procédé de programmation d'une cellule mémoire comportant un transistor à grille flottante, en une succession de cycles de programmation comprenant chacun une étape de vérification de l'état de la cellule mémoire suivie de l'application d'une impulsion d'une tension de programmation à la cellule mémoire si l'étape de vérification montre que la cellule n'est pas dans l'état programmé, l'étape de vérification comprenant une première lecture de la cellule mémoire en appliquant sur une grille de contrôle de la cellule mémoire une première tension de lecture supérieure à une tension de seuil de référence, la cellule mémoire étant considérée comme n'étant pas dans l'état programmé au vu de la première lecture si un courant de première lecture traversant la cellule mémoire est supérieur à un premier seuil, procédé dans lequel l'étape de vérification de la cellule mémoire comprend une seconde lecture de la cellule mémoire en appliquant sur sa grille de contrôle une seconde tension de lecture inférieure ou égale à la tension de seuil de référence, la cellule mémoire étant considérée comme n'étant pas dans l'état programmé au vu de la seconde lecture si un courant de seconde lecture traversant la cellule mémoire est supérieur à un second seuil, et dans lequel des impulsions de tension de programmation sont appliquées à la cellule mémoire tant que celle-ci est considérée comme n'étant pas dans l'état programmé au vu d'au moins l'une des deux lectures, sans excéder un nombre d'impulsions de programmation représentatif d'une défaillance de la cellule mémoire.

Selon un mode de réalisation, le second seuil est nul ou faible et de l'ordre de quelques centaines ou milliers de nanoampères.

Selon un mode de réalisation, la lecture de l'étape de vérification est faite en comparant le courant traversant la cellule mémoire à un courant de référence formant le premier seuil traversant une cellule mémoire de référence présentant une courbe de transconductance non dégradée et dont la tension de seuil forme la tension de seuil de référence.

Selon un mode de réalisation, un courant d'offset formant le second seuil est injecté en parallèle avec la cellule mémoire de référence pour effectuer la seconde lecture.

Selon un mode de réalisation, le procédé comprend les étapes suivantes : au terme de la première lecture de l'étape de vérification, fournir un premier bit représentatif de l'état programmé ou effacé de la cellule mémoire au vu de la première lecture, au terme de la seconde lecture de l'étape de vérification, fournir un second bit représentatif de l'état programmé ou effacé de la cellule mémoire au vu de la seconde lecture, calculer un bit de double lecture par combinaison logique du premier et second bits, et appliquer une impulsion de tension de programmation à la cellule mémoire si le bit de double lecture présente une valeur logique déterminée.

Selon un mode de réalisation, le procédé comprend une étape de mémorisation du premier bit, une étape de mémorisation du second bit et une étape consistant à appliquer les premier et second bits à un circuit logique pour obtenir le bit de double lecture.

Selon un mode de réalisation, le procédé comprend les étapes suivantes : fournir des impulsions de tension de programmation, comparer un bit à enregistrer dans la cellule mémoire et le bit de double lecture, fournir un signal de contrôle qui présente une valeur déterminée qui inhibe l'application des impulsions de tension de programmation à la cellule mémoire, si le bit de double lecture présente une valeur logique inverse de la valeur déterminée ou si le bit à enregistrer présente une valeur logique d'effacement.

La présente invention concerne également un procédé de programmation collective d'une pluralité de cellules mémoire, dans lequel chaque cellule mémoire est programmée en appliquant individuellement à chaque cellule mémoire le procédé de programmation selon l'invention, le nombre d'impulsions de tension de programmation que peut recevoir chaque cellule mémoire pouvant être différent selon l'état de dégradation éventuel de la courbe de transconductance de chaque cellule mémoire.

La présente invention concerne également une mémoire comprenant des cellules mémoire comprenant chacune un transistor à grille flottante, un circuit de programmation et un circuit de lecture agencés pour appliquer à une cellule mémoire à programmer une succession de cycles de programmation comportant chacun une étape de vérification de la cellule mémoire suivie de l'application à la cellule mémoire d'une impulsion d'une tension de programmation si l'étape de vérification montre que la cellule mémoire n'est pas dans l'état programmé, le circuit de lecture étant agencé pour effectuer, au cours de chaque étape de vérification, une première lecture de la cellule mémoire en appliquant sur une grille de contrôle de la cellule mémoire une première tension de lecture supérieure à une tension de seuil de référence, et fournir un premier bit ayant une première valeur logique déterminée si un courant de première lecture traversant la cellule mémoire est supérieur à un premier seuil, mémoire dans laquelle le circuit de lecture est agencé pour effectuer, au cours de chaque étape de vérification, une seconde lecture de la cellule mémoire en appliquant sur sa grille de contrôle une seconde tension de lecture inférieure ou égale à la tension de seuil de référence, et fournir un second bit ayant une seconde valeur logique déterminée si un courant de seconde lecture traversant la cellule mémoire est supérieur à un second seuil, le circuit de programmation étant agencé pour appliquer des impulsions de tension de programmation à la cellule mémoire tant que le premier bit présente la première valeur logique ou que le second bit présente la seconde valeur logique, sans excéder un nombre d'impulsions de programmation représentatif d'une défaillance de la cellule mémoire.

Selon un mode de réalisation, le second seuil est nul ou faible et de l'ordre de quelques centaines ou milliers de nanoampères.

Selon un mode de réalisation, le circuit de lecture comprend un amplificateur de lecture comprenant une cellule mémoire de référence présentant une courbe de transconductance non dégradée et dont la tension de seuil forme la tension de seuil de référence, et des moyens pour comparer le courant de première lecture traversant la cellule mémoire à lire à un courant de référence traversant la cellule mémoire de référence et formant le premier seuil.

Selon un mode de réalisation, l'amplificateur de lecture comprend un générateur de courant d'offset agencé en parallèle avec la cellule mémoire de référence, le courant d'offset formant le second seuil.

Selon un mode de réalisation, le circuit de lecture comprend des moyens pour fournir un bit de double lecture par combinaison logique des premier et second bits.

Selon un mode de réalisation, le circuit de lecture comprend un comparateur série comportant des moyens de mémorisation du premier bit, des moyens de mémorisation du second bit, et un circuit logique pour combiner les premier et second bits, fournissant le bit de double lecture.

Selon un mode de réalisation, le circuit de programmation est agencé pour fournir un signal de contrôle qui inhibe l'application des impulsions de tension de programmation à la cellule mémoire si le bit de double lecture présente une valeur logique déterminée ou si un bit à enregistrer dans la cellule mémoire présente une valeur logique d'effacement.

Selon un mode de réalisation, les première et seconde lectures sont synchronisées par des signaux de contrôle pulsés comportant des impulsions décalées.

Ces objets, caractéristiques et avantages ainsi que d'autres de la présente invention seront exposés plus en détail dans la description suivante du procédé de l'invention et d'un exemple de réalisation d'une mémoire selon l'invention, faite à titre non limitatif en relation avec les figures jointes parmi lesquelles :

- les figures 1A, 1B précédemment décrites représentent respectivement une étape de lecture-vérification et une étape de programmation d'une cellule mémoire,
- la figure 2 précédemment décrite représente des courbes de distribution statistique de tensions de seuil de cellules mémoire et illustre le problème technique que résout l'invention,
- la figure 3 précédemment décrite représente des courbes de transconductance de cellules mémoire et illustre également le problème technique que résout l'invention,
- la figure 4 représente des courbes de transconductance d'une cellule mémoire dans l'état effacé et dans l'état programmé, et illustre le procédé de programmation selon l'invention,
- la figure 5 représente une courbe de distribution statistique de tensions de seuil de cellules mémoire dans l'état programmé, et illustre l'effet correctif qu'offre le procédé selon l'invention,
- la figure 6 représente un exemple d'architecture d'amplificateur de lecture permettant de mettre en oeuvre le procédé selon l'invention,
- la figure 7 est un schéma bloc représentant l'architecture générale d'une mémoire comprenant des moyens de programmation selon l'invention,
- la figure 8 représente des exemples de réalisation d'éléments représentés sous forme de bloc en figure 7, et
- les figures 9A à 9F sont des chronogrammes de signaux apparaissant dans la mémoire de la figure 7, et illustrent le déroulement d'une phase de programmation selon l'invention.

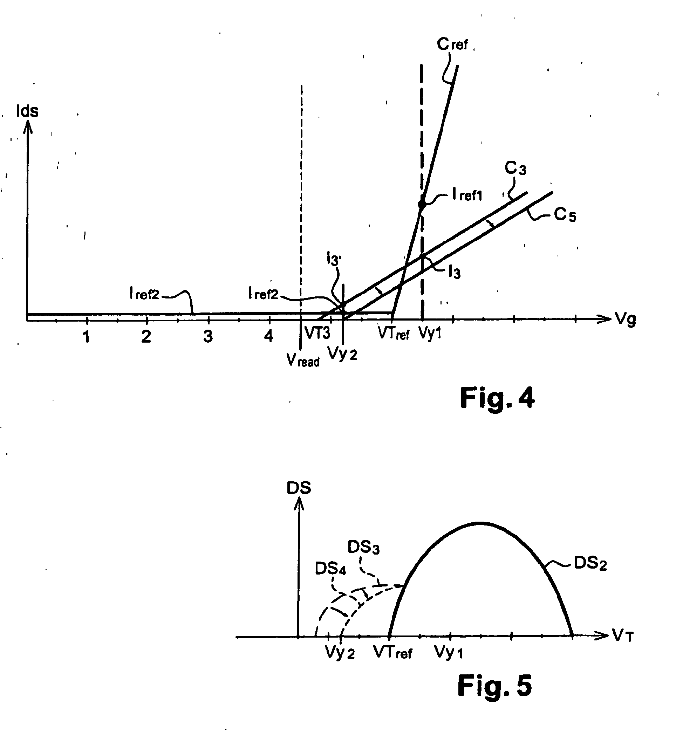

La figure 4 représente la courbe de transconductance de référence Cref et la courbe de transconductance dégradée C3 décrites plus haut. La courbe Cref présente une tension de seuil VTref, par exemple 6V. La courbe de transconductance C3 présente une tension de seuil VT3 inférieure à VTref et une pente nettement plus faible que celle de la courbe Cref. Comme exposé plus haut, VTref représente la tension de seuil minimale visée pour une cellule mémoire programmée, mais ne peut être atteinte avec le procédé de vérification-programmation classique si la cellule mémoire présente une dégradation de transconductance.

Selon l'invention, une cellule mémoire à programmer, notamment la cellule de transconductance C3, est lue au moyen de deux tensions de lecture différentes au cours de l'étape de vérification qui précède l'application d'une impulsion de tension de programmation Vpp.

Comme représenté sur la figure 4, la première lecture-vérification est faite en appliquant sur la grille de contrôle du transistor à grille flottante de la cellule mémoire une tension de lecture-vérification Vy1 identique à la tension Vy1 du procédé de lecture-vérification classique. La lecture est faite en référence à la courbe de transconductance de référence Cref, soit en référence à un courant Iref1 tel que Iref1=Cref(Vy1). Si le courant I3 traversant la cellule mémoire, tel que I3=C3(Vy1), est inférieur au courant Iref1, la cellule est considérée comme programmée au regard de la première lecture-vérification mais cette condition n'est pas suffisante, selon l'invention, pour arrêter l'application des impulsions de tension de programmation.

Selon l'invention, la seconde lecture-vérification est faite en appliquant sur la grille de contrôle de la cellule mémoire une tension de lecture-vérification Vy2 inférieure ou égale à VTref, par exemple 5,25V, et en observant si le courant I3' traversant la cellule mémoire est supérieur à un courant de référence Iref2 qui est de préférence nul ou de très faible valeur, par exemple de 1 à 2 microampères et de façon générale de l'ordre de quelques centaines ou milliers de nanoampères. Si le courant I3' est supérieur à Iref2, cela signifie que la cellule mémoire présente une tension de seuil inférieure à Vy2 puisqu'elle est passante. La cellule mémoire n'est donc pas complètement programmée puisque la tension Vy2 est elle-même inférieure ou égale à la tension de seuil VTref visée pour une cellule mémoire programmée. Dans ces conditions, des impulsions de tension de programmation Vpp supplémentaires sont appliquées à la cellule mémoire, au moins jusqu'à ce que le courant I3' soit inférieur ou égal à Iref2. Ainsi, sur la figure 4, la courbe C3 continue à se déplacer vers la droite jusqu'à former une courbe C5 présentant une tension de seuil VT5 au moins égale à Vy2 (la dernière impulsion de tension de programmation pouvant porter la tension de seuil à une valeur supérieure). Dans l'art antérieur, la cellule mémoire présentant la courbe de transconductance C3 aurait été considérée comme programmée lors de la lecture-vérification avec la tension Vy1, de sorte qu'elle aurait présenté la tension de seuil VT3 au terme du processus de programmation.

La figure 5 représente la correction que le procédé de l'invention permet d'apporter à l'anomalie DS3 constatée dans la distribution de tension de seuil. La protubérance que constitue la courbe DS3 par rapport à la courbe de distribution attendue DS2 est sensiblement réduite pour former une courbe DS4 plus proche de la courbe DS2 que la courbe DS3. Plus particulièrement, la distribution statistique corrigée DS4 présente une limite à gauche égale à la tension de seconde lecture-vérification Vy2. Ainsi, en théorie, la tension Vy2 idéale doit être proche de VTref et pratiquement égale à VTref (par valeurs inférieures) pour obtenir la distribution attendue DS2. En pratique, des contraintes techniques imposée par le fonctionnement des amplificateurs de lecture, font que la tension Vy2 doit de préférence se trouver à une certaine distance de VTref. En tout état de cause, la présente invention permet de ramener les tensions de seuil de cellules mémoire ayant une transconductance dégradée dans une fourchette de valeurs suffisamment étroite pour pallier le risque de dérive évoqué plus haut.

Un aspect de l'invention concerne la réalisation d'un amplificateur de lecture permettant de lire une cellule mémoire à la fois avec la tension Vy1 et la tension Vy2. En effet, un amplificateur de lecture classique nécessite un courant minimal pour que ses branches de comparaison fonctionnent correctement, et ne permet pas d'effectuer la seconde lecture selon l'invention en raison du courant de référence Iref2, qui est trop faible pour être fixé par une courbe de transconductance d'une cellule mémoire de référence. Ici, l'idée de l'invention est de prévoir, dans un amplificateur de lecture, un générateur de courant fournissant un courant d'offset égal à Iref2. Ce courant est faible mais suffisant pour que l'amplificateur de lecture ne se bloque pas et puisse comparer ce courant avec le courant traversant la cellule mémoire en cours de programmation.

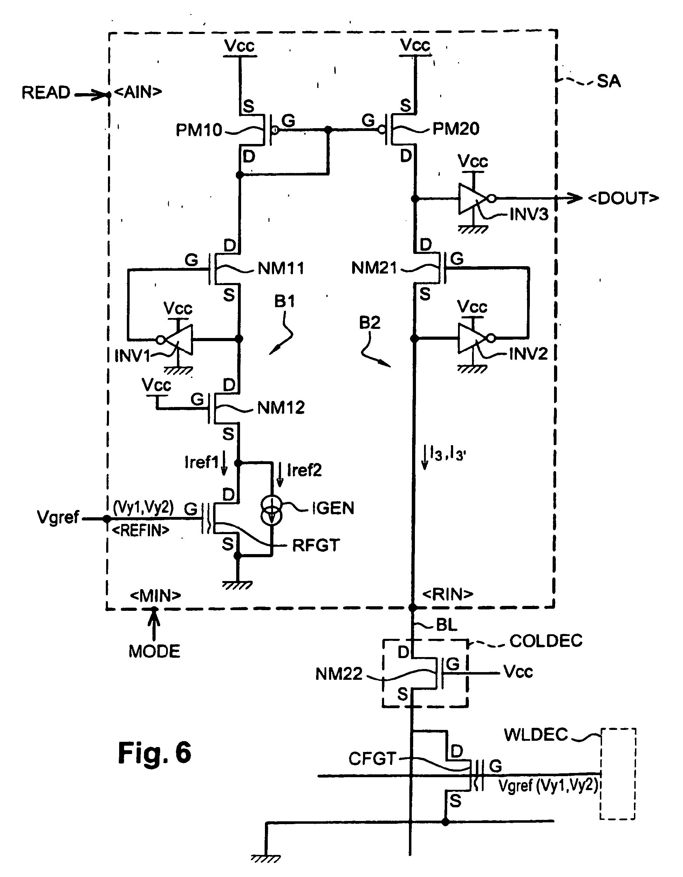

La figure 6 représente un exemple de réalisation d'un tel amplificateur de lecture SA. L'amplificateur comprend deux branches B1, B2 agencées en miroir de courant. La branche B1 comprend un transistor PMOS PM10, deux transistors NMOS NM11, NM12, et une cellule mémoire de référence formée par un transistor à grille flottante RFGT. La branche B2 comprend un transistor PMOS PM20 et un transistor NMOS NM21.

Le transistor PM10 reçoit une tension d'alimentation Vcc sur sa source (S), sa grille (G) est connectée à son drain (D) ainsi qu'à la grille du transistor PM20 (montage en miroir de courant). Le drain du transistor PM10 est relié à la source du transistor NM11 dont la source est ramenée sur la grille par l'intermédiaire d'une porte inverseuse INV1 alimentée par la tension Vcc. La source du transistor NM11 est reliée au drain du transistor NM12 dont la grille est polarisée par la tension Vcc (montage cascode). La source du transistor NM12 est reliée au drain de la cellule mémoire de référence RFGT. La source de la cellule mémoire RFGT est reliée à la masse et sa grille est reliée à une entrée REFIN de l'amplificateur de lecture, sur laquelle est appliquée une tension de référence Vgref. Dans la branche B2 le transistor PM20 reçoit la tension Vcc sur sa source (S), son drain PM20 est relié à la source du transistor NM21 dont la source est ramenée sur la grille par l'intermédiaire d'une porte inverseuse INV2 alimentée par la tension Vcc. La source du transistor NM21 forme une entrée de lecture RIN de l'amplificateur SA. L'amplificateur SA comprend également une sortie de donnée DOUT reliée ici au drain du transistor PM20 par l'intermédiaire d'une porte inverseuse INV3.

La cellule mémoire de référence RFGT présente la courbe de transconductance Cref décrite plus haut et une tension de seuil égale à VTref. Elle est traversée par un courant Iref1 quand Vgref=Vy1, et n'est pas passante quand Vgref=Vy2. Comme proposé plus haut, l'amplificateur SA comprend une source de courant IGEN en parallèle avec la cellule de référence RFGT, qui impose dans la branche B1 un courant d'offset égal au courant Iref2 lorsque la tension Vgref est égale à Vy2 et que la cellule mémoire de référence n'est pas passante (car Vy2 < VTref).

Lorsqu'une cellule mémoire formée par un transistor à grille flottante CFGT doit être lue, l'entrée RIN de l'amplificateur est connectée au drain du transistor à grille flottante CFGT par l'intermédiaire d'au moins un transistor NM22 appartenant à un décodeur de colonne COLDEC, dont la grille est polarisée par la tension Vcc. Les éléments de la branche B2 de l'amplificateur, une fois connectés au transistor NM22 et à la cellule mémoire CFGT, forment une branche miroir ayant sensiblement la même structure que la branche B1.

La lecture de la cellule mémoire CFGT est déclenchée en appliquant sur sa grille de contrôle la même tension de référence Vgref que celle appliquée à la cellule mémoire de référence RFGT, soit la tension Vy1 ou la tension Vy2, tandis que la source de la cellule mémoire CFGT est reliée à la masse. La tension Vgref est appliquée à la cellule mémoire CFGT par l'intermédiaire d'un décodeur de ligne de mot WLDEC et d'une ligne de mot WL à laquelle la grille de contrôle de la cellule mémoire CFGT est connectée.

Lorsque la tension Vgref=Vy1 est appliquée, le noeud de sortie de l'amplificateur (drain du transistor PM20) est tiré vers la masse si le courant dans la cellule mémoire CFGT est supérieur au courant de référence Iref1 traversant la cellule mémoire de référence RFGT. La sortie DOUT passe à 1 ce qui signifie par convention que la cellule mémoire CFGT est lue comme étant dans l'état effacé. Dans le cas contraire, le noeud de sortie est tiré vers la tension Vcc et la sortie DOUT passe à 0, ce qui signifie par convention que la cellule mémoire est lue comme étant dans l'état programmé.

Lorsque la tension Vgref=Vy2 est appliquée, le noeud de sortie de l'amplificateur (drain du transistor PM20) est tiré vers la masse si le courant dans la cellule mémoire CFGT est supérieur au courant de référence Iref2 imposé dans la branche B1 par le générateur de courant IGEN, la cellule mémoire de référence RFGT étant bloquée. La sortie DOUT passe alors à 1. Dans le cas contraire, le noeud de sortie est tiré vers la tension Vcc et la sortie DOUT passe à 0.

Ainsi, selon l'invention, la cellule mémoire n'est considérée comme programmée que si l'amplificateur de lecture fournit la valeur logique de programmation, ici 0, au cours des deux étapes de lecture. Dans le cas contraire, des impulsions de tension de programmation continuent d'être appliquées à la cellule mémoire.

Dans ce qui précède, seuls les éléments nécessaires à l'exécution des étapes de lecture-vérification selon l'invention ont été décrits. Dans un mode de réalisation complet de l'amplificateur de lecture, celui-ci comprend également une entrée d'activation AIN pilotée par un signal READ, et des moyens de mise sous tension. Il comprend également une entrée MIN recevant un signal MODE, au moins une autre cellule de référence présentant une courbe de transconductance appropriée à une lecture normale faite avec la tension Vread, et des moyens pour sélectionner cette cellule mémoire de référence ou la cellule mémoire RFGT selon la valeur du signal MODE qui définit ainsi si une lecture doit être faite en mode vérification ou en mode normal. Ces divers moyens ne sont pas représentés sur la figure dans un souci de simplicité, et sont en soi connus de l'homme de l'art.

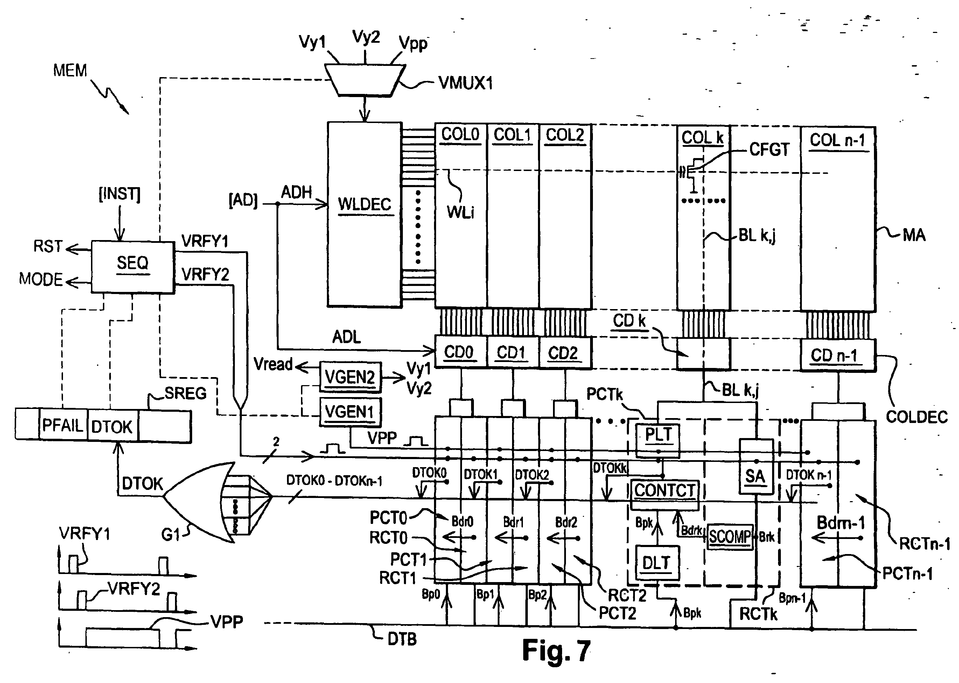

On décrira maintenant en relation avec la figure 7 un exemple de réalisation d'une mémoire MEM comprenant un dispositif de programmation mettant en oeuvre le procédé selon l'invention.

La mémoire comprend un plan mémoire MA comportant des cellules mémoire de type Flash formées par des transistors à grille flottante CFGT reliés à des lignes de mot WLi et à des lignes de bit BLk,j. Les lignes de bit sont regroupées en n colonnes physiques COLk (COL0, COL1, COL2,...COLn-1) k étant un indice de colonne allant de 0 à n-1. Chaque colonne physique de rang k comprend J lignes de bit BLk,j, j étant un indice allant de 0 à J-1. Les lignes de bit BLk,j sont reliées aux drains des transistors à grille flottante CFGT, tandis que les lignes de mot WLi sont reliées aux grilles de commande des transistors CFGT. Les cellules mémoire reliées aux lignes de bit BLk,j d'une colonne COLk contiennent des bits de même poids. Ainsi, un mot binaire de n bits est enregistré dans n cellules mémoire se trouvant chacune dans une colonne physique déterminée. Une page de la mémoire est formée par l'ensemble des cellules mémoire reliées à la même ligne de mot WLi et comprend J mots de n bits chacun.

La mémoire comprend également un décodeur de ligne de mot WLDEC relié aux lignes de mot du plan mémoire, un décodeur de colonne COLDEC relié aux lignes de bit du plan mémoire, un séquenceur SEQ, un bus d'adresse ADB véhiculant des adresses de mot AD, et un bus de données DTB.

Le séquenceur, à logique câblée ou à microprocesseur, exécute des instructions (INST) d'effacement et de programmation de cellules mémoire, ainsi que des instructions de lecture de données dans le plan mémoire.

En phase de programmation, le séquenceur SEQ fournit deux signaux de contrôle pulsés VRFY1, VRFY2 qui permettent de cadencer les deux étapes de lecture-vérification selon l'invention. Les signaux VRFY1, VRFY2 sont formés par des impulsions décalées, le signal VRFY1 étant d'abord à 1 et le signal VRFY2 à 0, puis le signal VRFY1 étant à 0 et le signal VRFY2 à 1.

La mémoire comprend également des générateurs de tension VGEN1, VGEN2 contrôlés par le séquenceur. En phase de programmation, le générateur VGEN1 fournit des impulsions de tension de programmation Vpp décalées relativement aux impulsions VRFY1, VRFY2, de sorte qu'un cycle de programmation comprend une impulsion VRFY1, puis une impulsion VRFY2, puis une impulsion de tension Vpp, comme représenté en bas à gauche de la figure 7. Les impulsions de vérification VRFY1, VRFY2 sont plus courtes que les impulsions de programmation, car la durée d'une opération de lecture est généralement très courte, par exemple quelques dizaines de nanosecondes contre quelques microsecondes pour une impulsion de programmation. Le générateur VGEN2 fournit les tensions de lecture-vérification Vy1, Vy2 en phase de programmation, et fournit la tension de lecture Vread en phase de lecture.

Le décodeur WLDEC reçoit une adresse de ligne de mot ADH formée par les bits d'adresse de poids fort de l'adresse AD présente sur le bus d'adresse, et applique une tension de sélection déterminée sur la ligne de mot sélectionnée, soit aux grilles de contrôle des cellules mémoire reliées à cette ligne de mot. La tension de sélection est fournie au décodeur WLDEC par un multiplexeur de tension VMUX1 contrôlé par le séquenceur. En phase de programmation, le multiplexeur VMUX1 reçoit en entrée les tensions de lecture-vérification Vy1, Vy2 et la tension Vpp, et fournit au décodeur WLDEC les tensions de sélection suivantes :

- la tension Vy1 quand le signal de contrôle VRFY1 est à 1,
- la tension Vy2 quand le signal de contrôle VRFY2 est à 1, et
- la tension Vpp quand une impulsion de tension Vpp est - la tension Vpp quand une impulsion de tension Vpp est émise par le générateur VGEN1.

Ainsi, les grilles de contrôle des cellules mémoire sélectionnées reçoivent successivement les tensions Vy1, Vy2, Vpp pendant des étapes correspondant à la durée des impulsions VRFY1, VRFY2, Vpp.

Le décodeur COLDEC reçoit une adresse de colonne logique ADL formée par les bits de poids faible de l'adresse AD. Une telle adresse de colonne logique correspond à l'adresse d'un mot de n bits, et permet de sélectionner une ligne de bit et une seule dans chacune des n colonnes physiques. Le décodeur COLDEC comprend ainsi n blocs de décodage CDk (CD0, CD1,...CDn-1). Chaque bloc de décodage CDk est associé à une colonne électrique COLk et comprend n entrées reliées aux lignes de bit de la colonne et une sortie. Chaque bloc de décodage CDk sélectionne sur sa sortie une ligne de bit BLk,j de la colonne correspondante COLk, en fonction de l'adresse de colonne logique ADL.

La sortie de chaque bloc de décodage CDk est reliée d'une part à un circuit de lecture RCTk selon l'invention (RCT0, RCT1, ...RCTn-1) et d'autre part à un circuit de programmation PCTk (PCT0, PCT1,... PCTn-1). Chaque circuit de lecture RCTk comprend un amplificateur de lecture SA et un comparateur série SCOMP. L'amplificateur de lecture SA, dont un exemple de structure a été décrit plus haut, a une entrée de lecture reliée à une sortie du bloc de décodage CDk et une sortie reliée d'une part au bus de données DTB et d'autre part au comparateur SCOMP. La sortie du comparateur SCOMP est reliée au circuit de programmation PCTk de rang correspondant. Chaque circuit de programmation PCTk comprend un verrou de données DLT (data latch), un circuit de contrôle CONTCT et un verrou de programmation PLT ("program latch"). L'entrée du verrou DLT est reliée au bus de données DTB et reçoit un bit Bpk (Bp0, Bp1...Bpn-1) à enregistrer dans une cellule mémoire de la colonne physique de rang correspondant. Le circuit de contrôle CONTCT a une entrée reliée à la sortie du verrou DLT pour recevoir le bit Bpk, et un autre entrée reliée à la sortie du comparateur SCOMP, recevant un bit Bdrk (Bdrk0, Bdrk1,....Bdrkn-1) fourni par le comparateur SCOMP, et une sortie fournissant un signal DTOKk. Le verrou de programmation PLT a une sortie reliée à la sortie du bloc de décodage CDk, une entrée de commande recevant le signal DTOKk, une entrée de déclenchement recevant le signal de vérification VRFY2 (commun à tous les verrous de programmation) et une entrée recevant la tension de programmation Vpp.

L'enregistrement dans le plan mémoire d'un mot binaire comprenant n bits Bp0, Bp1, Bp2,...Bpk...Bpn-1 comprend les étapes suivantes :

- l'application d'une adresse de ligne de mot ADH (adresse de page) au décodeur WLDEC et l'application au décodeur COLDEC d'une adresse de colonne logique ADL correspondant au rang du mot cible dans la page sélectionnée, le décodeur sélectionnant n cellules mémoire correspondantes,
- l'effacement de la page sélectionnée par le décodeur WLDEC (tous les bits sont mis à 1),
- le chargement des bits Bp0, Bp1, Bp2,...Bpk, Bpn-1 dans les verrous DLT des circuits de programmation PCTk, à raison d'un bit par verrou,
- l'application à chaque cellule mémoire à programmer de cycles de programmation, jusqu'à ce que toutes les cellules mémoire soit programmées.

Chaque cycle de programmation est cadencé par une impulsion VRFY1, une impulsion VRFY2 et une impulsion Vpp. Sur front montant de l'impulsion VRFY1, le décodeur WLDEC reçoit la tension Vy1 et l'applique à la ligne de mot sélectionnée, de sorte que toutes les cellules mémoire de la ligne de mot reçoivent sur leur grille la tension Vy1. Simultanément, chaque amplificateur de lecture lit l'une des cellules mémoire sélectionnées et fournit le premier bit Brk1. Sur front descendant de l'impulsion VRFY1, chaque comparateur série SCOMP présent dans chaque circuit de lecture RCTk mémorise le bit Brk1 correspondant (k étant un indice allant de 1 à n comme indiqué plus haut). Sur front montant de l'impulsion VRFY2, le décodeur WLDEC reçoit la tension Vy2 et l'applique à la ligne de mot sélectionnée. Simultanément, chaque amplificateur de lecture lit l'une des cellules mémoire sélectionnées et fournit le second bit Brk2. Sur front descendant de l'impulsion VRFY2, chaque comparateur série SCOMP mémorise le bit Brk2 correspondant.

Lorsque la seconde lecture-vérification est terminée, la sortie du comparateur série SCOMP de chaque circuit de lecture RCTk fournit un bit Bdrk. Le bit Bdrk est le résultat de la lecture en deux étapes de la cellule mémoire et est égal à :

$$(1) \quad \textbf{Bdrk = Brk1 + Brk2}$$

"+" étant la fonction OU.

Ainsi, le bit Bdrk passe à 0 (valeur logique d'effacement) si les deux bits Brk1 et Brk2 sont eux-mêmes égaux à 0. Comme cela a été vu plus haut, une cellule mémoire qui n'est pas encore totalement programmée (voire une cellule dans l'état effacé) mais qui est vue comme étant programmée lors de la lecture faite avec la tension Vy1 en raison d'une dégradation de sa transconductance, sera ici détectée car la lecture de cette cellule avec la tension Vy2 montre que la cellule présente un courant Ids non nul et que sa tension de seuil se situe donc en dessous du seuil recherché pour une cellule mémoire programmée. Dans un tel cas, le bit Brk1 est égal à 0 mais le bit Brk2 est égal à 1, de sorte que le bit Bdrk issu de la double lecture reste égal à 1.

Le circuit de contrôle CONTCT est un circuit logique asynchrone et le signal DTOKk fourni par ce circuit est fonction du bit à écrire Bpk et du bit Bdrk lu en deux étapes. Le signal DTOKk est par exemple le résultat de l'équation logique suivante :

$$\text{(2)} \quad \text{DTOKk} = \text{Bpk} + /\text{Bpk}*/\text{Bdrk}$$

"*" étant la fonction ET.

Ainsi, sur front descendant de l'impulsion VRFY2, le signal DTOKk passe à 1 dans les cas suivants :

- si le bit à enregistrer Bpk est égal à 1, ce qui signifie qu'il n'y a pas de programmation à effectuer sur la cellule mémoire, et
- si le bit à enregistrer Bpk est égal à 0 et le bit lu Bdrk est égal à 0 (résultat de la double lecture), ce qui signifie qu'il n'est plus nécessaire d'appliquer des impulsions de tension de programmation à la cellule mémoire car celle-ci est programmée.

Lorsque l'impulsion de tension Vpp apparaît, le verrou de programmation PLT est transparent si le signal DTOKk est à 0 ou se bloque si le signal DTOKk est à 1. Si le verrou est transparent, il transmet l'impulsion de tension de programmation Vpp à la ligne de bit lorsque cette impulsion est émise.

Pour chaque cellule mémoire à programmer (Bpk=0), le cycle de programmation est répété jusqu'à ce que les bits Brk1 et Brk2 soient égaux à 0 (Bdrk=0). Les cellules mémoire programmée simultanément peuvent donc recevoir, les unes relativement aux autres, un nombre d'impulsions de programmation différent, si elles n'ont pas la même tension de seuil au commencement du cycle de programmation et/ou si elles présentent différentes dégradations de leurs courbes de transconductance.

Afin de contrôler l'opération de programmation dans son ensemble, les signaux DTOKk (DTOK0 à DTOKn-1) sont collectés par une porte logique G1 de type ET dont la sortie délivre un signal collectif DTOK qui ne passe à 1 que lorsque tous les signaux individuels DTOKk sont à 1. Le signal DTOK est chargé en tant que drapeau dans un registre d'état SREG de la mémoire, et est rafraîchi à chaque cycle de programmation. Le séquenceur SEQ arrête l'émission des impulsions de tension de programmation Vpp (arrêt du générateur VGEN1) lorsque le signal collectif DTOK passe à 1. Le séquenceur arrête également l'émission des impulsions de tension de programmation lorsque le signal DTOK ne passe pas à 1 après application de N impulsions de tension de programmation. Cela signifie qu'au moins une cellule mémoire est défaillante et ne peut être programmée. Un drapeau PFAIL (Program Fail) est mis à 1 dans le registre SREG, pour indiquer à l'utilisateur une erreur de programmation.

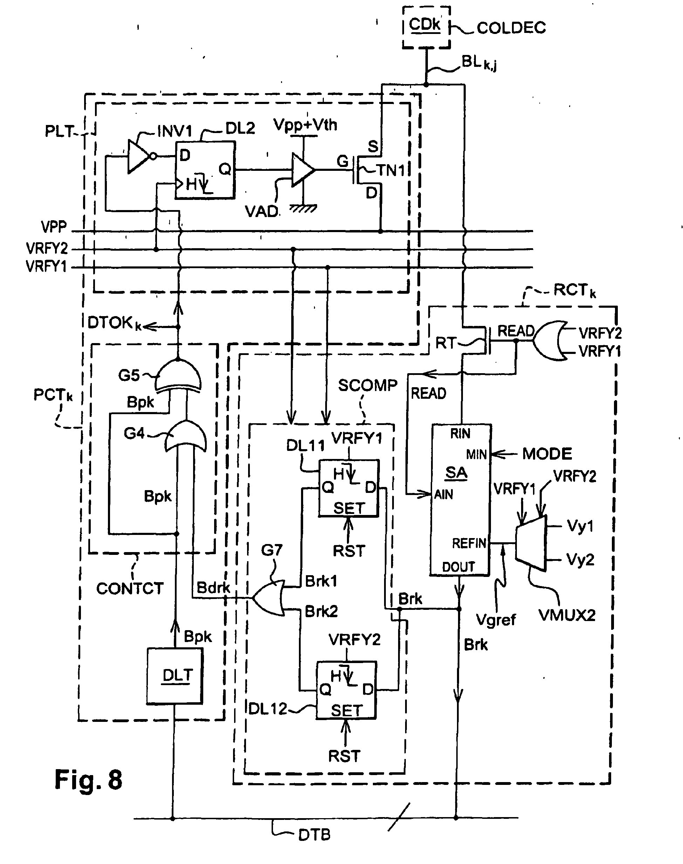

La figure 8 représente un exemple de réalisation d'un circuit de programmation PCTk et d'un circuit de lecture RCTk selon l'invention.

Le verrou de programmation PLT comprend une porte inverseuse INV1, une bascule D synchrone DL2, un adaptateur de tension VAD et un transistor NMOS TN1. La porte inverseuse reçoit le signal DTOKk fourni par le circuit de contrôle CONTCT et applique le signal DTOKk inversé sur l'entrée D de la bascule DL2, dont la sortie Q est appliquée sur l'entrée de l'adaptateur de tension VAD. Ce dernier est alimenté par une tension Vpp+VTH, VTH étant la tension de seuil du transistor TN1, et sa sortie pilote la grille du transistor TN1. La sortie de l'adaptateur VAD transforme un signal logique égal à 1 fourni par la bascule DL2 en un signal de tension Vpp+VTH, tandis qu'un signal logique à 0 est recopié sous forme de signal de tension nulle qui provoque le blocage du transistor TN1. L'entrée de déclenchement H de la bascule DL2, active sur front descendant, reçoit les impulsions du signal VRFY2. Le drain du transistor TN1 reçoit les impulsions de tension de programmation Vpp. La source du transistor TN1 est reliée à une ligne de bit BLk, j via le décodeur de colonne. Ainsi, la sortie Q de la bascule DL2 est rafraîchie à chaque front descendant du signal VRFY2, et recopie la valeur présente sur l'entrée D. Si le signal DTOKk est à 0, la sortie Q passe à 1 et l'adaptateur fournit la tension Vpp+VTH à la grille du transistor TN1, qui devient ou reste passant. Lorsque l'impulsion de tension Vpp est émise, celle-ci est transmise par le transistor TN1 à la ligne de bit BLk,j et une cellule mémoire sélectionnée reçoit la tension de programmation Vpp.

Le circuit de contrôle CONTCT comprend une porte logique G4 de type OU qui reçoit en entrée le bit à enregistrer Bpk et le bit Bdrk. La sortie de la porte G4 est appliquée sur une entrée d'une porte G5 de type NON OU EXCLUSIF (NXOR) recevant sur une seconde entrée le bit à enregistrer Bpk. La sortie de la porte G5 fournit le signal DTOKk, qui est égal à :

$$(3) \quad DTOKk = Bpk + /Bpk*/Bdrk + Bpk*Bdrk$$

soit :

$$(3bis) \quad DTOKk = Bpk*(1+Bdrk) + /Bpk*/Bdrk$$

soit encore :

$$(3ter) \quad DTOKk = Bpk + /Bpk*/Bdrk,$$

cette équation étant ainsi identique à l'équation 2 décrite plus haut.

L'amplificateur SA présente la structure décrite en relation avec la figure 6 et comporte les entrées RIN, MIN, AIN, REFIN et la sortie de données DOUT. L'entrée de lecture RIN est reliée à une ligne de bit BLk,j par l'intermédiaire du bloc de décodage CDk de rang correspondant ainsi que par l'intermédiaire d'un transistor de lecture RT de type NMOS. Le transistor RT, prévu pour isoler l'entrée RIN de l'amplificateur SA des impulsions de tension Vpp appliquées sur la ligne de bit, est agencé entre la sortie du bloc de décodage CDk et l'entrée RIN. Il est piloté par un signal READ fourni ici par la sortie d'une porte G6 de type OU recevant en entrée les signaux VRFY1, VRFY2. Le transistor RT est ainsi passant pendant les étapes de lecture-vérification, lorsque le signal READ est égal à 1. L'entrée MIN reçoit le signal MODE qui est fourni par le séquenceur (fig. 7) et permet de faire basculer l'amplificateur SA dans le mode de fonctionnement approprié (mode lecture-vérification ou mode de lecture simple) en sélectionnant la cellule de référence correspondante (seule la cellule de référence du mode de lecture-vérification étant représentée en figure 6, comme indiqué plus haut). L'entrée d'activation AIN reçoit le signal READ, de sorte que les branches de comparaison de courant de l'amplificateur sont activées quand l'un des signaux VRFY1, VRFY2 est à 1. Enfin, la tension de référence Vgref appliquée sur l'entrée REFIN est fournie ici par un multiplexeur de tension VMUX2 recevant en entrée les tensions de lecture Vy1, Vy2. Le multiplexeur est piloté par les signaux VRFY1, VRFY2 de manière que Vgref soit égal à Vy1 quand VRFY1 est égal à 1 et que Vgref soit égal à Vy2 quand VRFY2 est égal à 1.

Les phases de lecture du plan mémoire, en soi classiques, ne feront pas ici l'objet d'une description détaillée. Au cours des phases de lecture, l'un des signaux VRFY1, VRFY2 est utilisé en tant que signal de lecture équivalent au signal de lecture d'une mémoire classique, pour porter à 1 le signal READ. De même, l'un des deux chemins de conduction véhiculant les tensions Vy1, Vy2 est utilisé pour véhiculer la tension de lecture Vread (Cf. figures 3 et 4) pendant les phases de lecture.

Le comparateur série SCOMP comprend deux bascules D synchrones DL11, DL12. La bascule DL11 a une entrée D connectée à la sortie DOUT de l'amplificateur de lecture SA, une entrée d'horloge H recevant le signal VRFY1, active sur front descendant, et une sortie Q fournissant le bit Brk1, connectée à une première entrée d'une porte G7 de type OU. La bascule DL12 a une entrée D également connectée à la sortie DOUT de l'amplificateur de lecture SA, une entrée d'horloge H recevant le signal VRFY2, active sur front descendant, et une sortie Q fournissant le bit Brk2 et connectée à une autre entrée de la porte G7. Chaque bascule DL11, DL12 présente également une entrée SET recevant un signal RST fourni par le séquenceur SEQ, et est remise à 1 (sortie Q=1) au commencement d'une opération de programmation. La sortie de la porte G7 fournit le bit Bdrk.

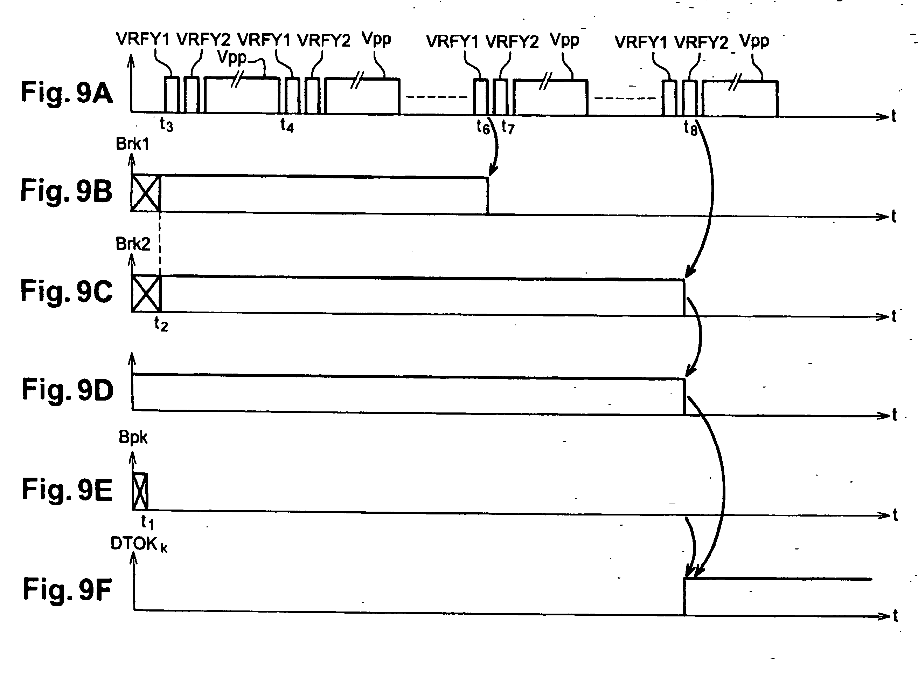

Les figures 9A à 9F sont des chronogrammes illustrant la programmation de cellules mémoire. La figure 9A représente les impulsions de contrôle VRFY1, VRFY2 et les impulsions de tension Vpp. Les figures 9B, 9C représentent respectivement les bits Brk1, Brk2 à la sortie des bascules D11, D12. La figure 9D représente le bit Bdrk à la sortie du comparateur SCOMP. La figure 9E représente le bit Bpk chargé dans le verrou de donnée DLT. La figure 9F représente le signal DTOKk. On suppose ici que la cellule mémoire a été préalablement effacée et qu'elle présente une transconductance dégradée, qui ne pourra être détecté qu'à l'étape de lecture-vérification faite avec la tension Vy2. On suppose également que le bit Bpk à écrire dans la cellule mémoire est égal à 0 et que le 0 correspond par convention à la valeur logique de programmation (valeur lue dans une cellule mémoire programmée).

A un instant t0 le bit Bpk (fig. 9E) est chargé dans le verrou DLT dont la sortie passe ainsi à 0. A un instant t2 les bascules D11, D12 sont mises à 1 (signal RST sur l'entrée SET) de sorte que les bits Brk1, Brk2 sont forcés à 1. A un instant t3 commence le premier cycle de programmation proprement dit, comprenant l'étape de lecture-vérification (VRFY=1) faite avec la tension de lecture Vy1, l'étape de lecture-vérification (VRFY=2) faite avec la tension de lecture Vy2, et l'étape de programmation (Vpp=1 sur le chronogramme de la figure 9A signifiant que l'impulsion de tension Vpp est émise). A un instant t6 intervenant après un nombre déterminé de cycles de programmation, le bit Brk1 passe à 0 sur front descendant du signal VRFY1. Cela signifie que la cellule mémoire a été lue comme programmée par l'amplificateur de lecture SA lors de l'étape de lecture-vérification faite avec la tension Vy1. Toutefois, à un instant t7 correspondant au front descendant de l'impulsion suivante du signal VRFY2, le bit Brk2 reste à 1, ce qui signifie que la cellule mémoire a été lue comme effacée (lecture d'un 1) par l'amplificateur de lecture lors de l'étape de lecture-vérification faite avec la tension Vy2. Ainsi, le bit résultant Bdrk reste à 1 et les cycles de programmation continuent. A un instant t8 correspondant à un front descendant du signal VRFY2, le bit Brk2 passe à 0 ce qui signifie que la cellule a été lue comme programmée avec la tension de lecture-vérification Vy2. Le bit Brk1 étant déjà passé à 0 à l'instant t6, le passage à 0 du bit Brk2 entraîne le passage à 0 du bit résultant Bdrk, ce qui entraîne le passage à 1 du signal DTOKk. Ainsi, la sortie Q de la bascule DL2 (fig. 8) du verrou de programmation PLT reste 0 au cours des impulsions de tension Vpp suivantes, et la cellule mémoire ne reçoit plus la tension Vpp. La phase de programmation de la cellule mémoire est terminée et la détection du défaut de transconductance a permis de porter la tension de seuil de la cellule mémoire au moins jusqu'au seuil Vy2.

Il apparaîtra clairement à l'homme de l'art que le procédé et la mémoire selon l'invention sont susceptibles de diverses variantes de réalisation, notamment en ce qui concerne le séquencement des cycles de programmation, la structure des moyens permettant de contrôler les phases de lecture-vérification, la structure de l'amplificateur de lecture, etc.. Notamment, bien que l'on ait décrit un amplificateur de lecture utilisant une cellule mémoire de référence pour fixer le courant de seuil Iref1, ce courant peut être obtenu autrement, par exemple au moyen d'une source de courant stable en tension et en température.

La présente invention est par ailleurs applicable à divers types de mémoires dans lesquelles une opération de programmation est conduite en plusieurs cycles de vérification-programmation, notamment les mémoires Flash série, les mémoires Flash à entrées/sorties parallèles,... et n'est pas réservée aux mémoires Flash effaçables par page.

## Revendications

1.   Procédé de programmation d'une cellule mémoire comportant un transistor à grille flottante (CFGT), en une succession de cycles de programmation comprenant chacun une étape de vérification de l'état de la cellule mémoire suivie de l'application d'une impulsion d'une tension de programmation (Vpp) à la cellule mémoire si l'étape de vérification montre que la cellule n'est pas dans l'état programmé,
     l'étape de vérification comprenant une première lecture de la cellule mémoire en appliquant sur une grille de contrôle de la cellule mémoire une première tension de lecture (Vy1) supérieure à une tension de seuil de référence (VTref), la cellule mémoire étant considérée comme n'étant pas dans l'état programmé au vu de la première lecture si un courant (I3) de première lecture traversant la cellule mémoire est supérieur à un premier seuil (Iref1),
     **caractérisé en ce que** l'étape de vérification de la cellule mémoire comprend une seconde lecture de la cellule mémoire en appliquant sur sa grille de contrôle une seconde tension de lecture (Vy2) inférieure ou égale à la tension de seuil de référence (VTref), la cellule mémoire étant considérée comme n'étant pas dans l'état programmé au vu de la seconde lecture si un courant (I3') de seconde lecture traversant la cellule mémoire est supérieur à un second seuil (Iref2),
     et dans lequel des impulsions de tension de programmation sont appliquées à la cellule mémoire tant que celle-ci est considérée comme n'étant pas dans l'état programmé au vu d'au moins l'une des deux lectures, sans excéder un nombre d'impulsions de programmation représentatif d'une défaillance de la cellule mémoire.

2.   Procédé selon la revendication 1, dans lequel le second seuil (Iref2) est nul ou faible et de l'ordre de quelques centaines ou milliers de nanoampères.

3.   Procédé selon l'une des revendications 1 et 2, dans lequel la lecture de l'étape de vérification est faite en comparant le courant (I3) traversant la cellule mémoire à un courant de référence (Iref1) formant le premier seuil traversant une cellule mémoire de référence (RFGT) présentant une courbe de transconductance non dégradée et dont la tension de seuil forme la tension de seuil de référence (VTref).

4.   Procédé selon la revendication 3, dans lequel un courant d'offset formant le second seuil (Iref2) est injecté en parallèle avec la cellule mémoire de référence (RFGT) pour effectuer la seconde lecture.

5.   Procédé selon l'une des revendications 1 à 4, comprenant les étapes suivantes :

     - au terme de la première lecture de l'étape de vérification, fournir un premier bit (Brk1) représentatif de l'état programmé ou effacé de la cellule mémoire au vu de la première lecture,

- au terme de la seconde lecture de l'étape de vérification, fournir un second bit (Brk2) représentatif de l'état programmé ou effacé de la cellule mémoire au vu de la seconde lecture,
- calculer un bit de double lecture (Bdrk) par combinaison logique du premier et second bits, et
- appliquer une impulsion de tension de programmation à la cellule mémoire si le bit de double lecture (Bdrk) présente une valeur logique déterminée.

6. Procédé selon la revendication 5, comprenant une étape de mémorisation du premier bit (Brk1), une étape de mémorisation du second bit (Brk2) et une étape consistant à appliquer les premier et second bits à un circuit logique pour obtenir le bit de double lecture (Bdrk).

7. Procédé selon les revendications 5 et 6, comprenant les étapes suivantes :

   - fournir des impulsions de tension de programmation (Vpp),
   - comparer un bit à enregistrer (Bpk) dans la cellule mémoire et le bit de double lecture (Bdrk),
   - fournir un signal de contrôle (DTOKk) qui présente une valeur déterminée qui inhibe l'application des impulsions de tension de programmation à la cellule mémoire, si le bit de double lecture (Bdrk) présente une valeur logique inverse de la valeur déterminée ou si le bit à enregistrer présente une valeur logique d'effacement.

8. Procédé de programmation collective d'une pluralité de cellules mémoire, **caractérisé en ce que** chaque cellule mémoire est programmée en appliquant individuellement à chaque cellule mémoire le procédé de programmation selon l'une des revendications 1 à 7, le nombre d'impulsions de tension de programmation (Vpp) que peut recevoir chaque cellule mémoire pouvant être différent selon l'état de dégradation éventuel de la courbe de transconductance de chaque cellule mémoire.

9. Mémoire comprenant des cellules mémoire comprenant chacune un transistor à grille flottante (CFGT), un circuit de programmation (PCTk) et un circuit de lecture (RCTk, SA) agencés pour appliquer à une cellule mémoire à programmer (CFGT) une succession de cycles de programmation comportant chacun une étape de vérification de la cellule mémoire suivie de l'application à la cellule mémoire d'une impulsion d'une tension de programmation (Vpp) si l'étape de vérification montre que la cellule mémoire n'est pas dans l'état programmé, le circuit de lecture (RCTk, SA) étant agencé pour effectuer, au cours de chaque étape de vérification, une première lecture de la cellule mémoire en appliquant sur une grille de contrôle de la cellule mémoire une première tension de lecture (Vy1) supérieure à une tension de seuil de référence (VTref), et fournir un premier bit (Brk1) ayant une première valeur logique déterminée si un courant de première lecture (I3) traversant la cellule mémoire est supérieur à un premier seuil (Iref1) ,

   **caractérisée en ce que** le circuit de lecture (RCTk, SA) est agencé pour effectuer, au cours de chaque étape de vérification, une seconde lecture de la cellule mémoire en appliquant sur sa grille de contrôle une seconde tension de lecture (Vy2) inférieure ou égale à la tension de seuil de référence (VTref), et fournir un second bit (Brk2) ayant une seconde valeur logique déterminée si un courant (I3') de seconde lecture traversant la cellule mémoire est supérieur à un second seuil (Iref2),

   le circuit de programmation (PCTk) étant agencé pour appliquer des impulsions de tension de programmation (Vpp) à la cellule mémoire tant que le premier bit (Brk1) présente la première valeur logique ou que le second bit (Brk2) présente la seconde valeur logique, sans excéder un nombre d'impulsions de programmation représentatif d'une défaillance de la cellule mémoire.

10. Mémoire selon la revendication 9, dans laquelle le second seuil (Iref2) est nul ou faible et de l'ordre de quelques centaines ou milliers de nanoampères.

11. Mémoire selon l'une des revendications 9 et 10, dans laquelle le circuit de lecture (RCTk) comprend un amplificateur de lecture (SA) comprenant une cellule mémoire de référence (RFGT) présentant une courbe de transconductance (Cref) non dégradée et dont la tension de seuil forme la tension de seuil de référence (VTref), et des moyens pour comparer le courant (I3) de première lecture traversant la cellule mémoire à lire (CFGT) à un courant de référence (Iref1) traversant la cellule mémoire de référence et formant le premier seuil.

12. Mémoire selon la revendication 11, dans laquelle l'amplificateur de lecture (SA) comprend un générateur (IGEN) de courant d'offset (Iref2) agencé en parallèle avec la cellule mémoire de référence, le courant d'offset formant le second seuil.

13. Mémoire selon l'une des revendications 9 à 12, dans laquelle le circuit de lecture comprend des moyens pour fournir un bit de double lecture (Bdrk) par combinaison logique des premier (Brk1) et second bits (Brk2).

14. Mémoire selon la revendication 13, dans laquelle le circuit de lecture comprend un comparateur série (SCOMP) comportant des moyens (DL11) de mémorisation du premier bit (Brk1), des moyens (DL12) de mémorisation du second bit (Brk2), et un circuit logique (G7) pour combiner les premier et second bits, fournissant le bit de double lecture (Bdrk).

15. Mémoire selon l'une des revendications 13 et 14, dans laquelle le circuit de programmation (PCTk) est agencé pour fournir un signal de contrôle (DTOKk) qui inhibe l'application des impulsions de tension de programmation à la cellule mémoire si le bit de double lecture (Bdrk) présente une valeur logique déterminée ou si un bit (Bpk) à enregistrer dans la cellule mémoire présente une valeur logique d'effacement.

16. Mémoire selon l'une des revendications 9 à 15, dans laquelle les première et seconde lectures sont synchronisées par des signaux de contrôle pulsés (VRFY1, VRFY2) comportant des impulsions décalées.

## Claims

1. A method for programming a memory cell comprising a floating-gate transistor (CFGT), in a series of programming cycles each comprising a step of verifying the state of the memory cell followed by the application of a pulse of a programming voltage (Vpp) to the memory cell if the verify step shows that the cell is not in the programmed state, the verify step comprising a first reading of the memory cell by applying to a control gate of the memory cell a first read voltage (Vy1) greater than a reference threshold voltage (VTref), the memory cell being considered not to be in the programmed state with regard to the first reading if a first reading current (I3) passing through the memory cell is greater than a first threshold (Iref1),
**characterized in that** the step of verifying the memory cell comprises a second reading of the memory cell by applying to its control gate a second read voltage (Vy2) lower than or equal to the reference threshold voltage (VTref), the memory cell being considered not to be in the programmed state with regard to the second reading if a second reading current (I3') passing through the memory cell is greater than a second threshold (Iref2),
and wherein pulses of programming voltage are applied to the memory cell while the latter is considered not to be in the programmed state with regard to at least one of the two readings, without exceeding a number of programming pulses representative of a fault of the memory cell.

2. Method according to claim 1, wherein the second threshold (Iref2) is zero or low and in the order of a few hundred or thousand nanoamperes.

3. Method according to one of claims 1 and 2, wherein the verify step is read by comparing the current (I3) passing through the memory cell with a reference current (Iref1) forming the first threshold passing through a reference memory cell (RFGT) having a non-degraded transconductance curve and the threshold voltage of which forms the reference threshold voltage (VTref).

4. Method according to claim 3, wherein an offset current forming the second threshold (Iref2) is injected in parallel with the reference memory cell (RFGT) to perform the second reading.

5. Method according to one of claims 1 to 4, comprising the following steps of:

   - at the end of the first reading of the verify step, supplying a first bit (Brk1) representative of the programmed or erased state of the memory cell with regard to the first reading,
   - at the end of the second reading of the verify step, supplying a second bit (Brk2) representative of the programmed or erased state of the memory cell with regard to the second reading,
   - calculating a double reading bit (Bdrk) by logically combining the first and second bits, and
   - applying a pulse of programming voltage to the memory cell if the double reading bit (Bdrk) has a determined logic value.

6. Method according to claim 5, comprising a step of storing the first bit (Brk1), a step of storing the second bit (Brk2) and a step of applying the first and second bits to a logic circuit to obtain the double reading bit (Bdrk).

7. Method according to claims 5 and 6, comprising the following steps of:

- supplying pulses of programming voltage (Vpp),

- comparing a bit to be saved (Bpk) in the memory cell and the double reading bit (Bdrk),

- supplying a control signal (DTOKk) that has a determined value which inhibits the application of the pulses of programming voltage to the memory cell, if the double reading bit (Bdrk) has a logic value that is the opposite of the determined value or if the bit to be saved has a logic erase value.

8. A method for collectively programming a plurality of memory cells, **characterized in that** each memory cell is programmed by individually applying to each memory cell the programming method according to one of claims 1 to 7, the number of pulses of programming voltage (Vpp) that each memory cell can receive possibly being different depending on the possible state of degradation of the transconductance curve of each memory cell.

9. A memory comprising memory cells each comprising a floating-gate transistor (CFGT), a programming circuit (PCTk) and a read circuit (RCTk, SA) arranged for applying to a memory cell to be programmed (CFGT) a series of programming cycles each comprising a verify step of verifying the memory cell followed by the application to the memory cell of a pulse of a programming voltage (Vpp) if the verify step shows that the memory cell is not in the programmed state, the read circuit (RCTk, SA) being arranged for performing, during each verify step, a first reading of the memory cell by applying to a control gate of the memory cell a first read voltage (Vy1) greater than a reference threshold voltage (VTref), and supplying a first bit (Brk1) having a first determined logic value if a first reading current (I3) passing through the memory cell is greater than a first threshold (Iref1),
**characterized in that** the read circuit (RCTk, SA) is arranged for performing, during each verify step, a second reading of the memory cell by applying to its control gate a second read voltage (Vy2) lower than or equal to the reference threshold voltage (VTref) , and supplying a second bit (Brk2) having a second determined logic value if a second reading current (I3') passing through the memory cell is greater than a second threshold (Iref2),
the programming circuit (PCTk) being arranged for applying pulses of programming voltage (Vpp) to the memory cell while the first bit (Brk1) has the first logic value or the second bit (Brk2) has the second logic value, without exceeding a number of programming pulses representative of a fault of the memory cell.

10. Memory according to claim 9, wherein the second threshold (Iref2) is zero or low and in the order of a few hundred or thousand nanoamperes.

11. Memory according to one of claims 9 and 10, wherein the read circuit (RCTk) comprises a sense amplifier (SA) comprising a reference memory cell (RFGT) having a non-degraded transconductance curve (Cref) and the threshold voltage of which forms the reference threshold voltage (VTref), and means for comparing the first reading current (I3) passing through the memory cell to be read (CFGT) with a reference current (Iref1) passing through the reference memory cell and forming the first threshold.

12. Memory according to claim 11, wherein the sense amplifier (SA) comprises a generator (IGEN) of offset current (Iref2) arranged in parallel with the reference memory cell, the offset current forming the second threshold.

13. Memory according to one of claims 9 to 12, wherein the read circuit comprises means for supplying a double reading bit (Bdrk) by logically combining the first (Brk1) and second bits (Brk2).

14. Memory according to claim 13, wherein the read circuit comprises a serial comparator (SCOMP) comprising means (DL11) for storing the first bit (Brk1), means (DL12) for storing the second bit (Brk2), and a logic circuit (G7) to combine the first and second bits, supplying the double reading bit (Bdrk).

15. Memory according to one of claims 13 and 14, wherein the programming circuit (PCTk) is arranged for supplying a control signal (DTOKk) that inhibits the application of the pulses of programming voltage to the memory cell if the double reading bit (Bdrk) has a determined logic value or if a bit (Bpk) to be saved in the memory cell has a logic erase value.

16. Memory according to one of claims 9 to 15, wherein the first and second readings are synchronized by pulsed control signals (VRFY1, VRFY2) comprising offset pulses.

**Patentansprüche**

1. Verfahren zur Programmierung einer Speicherzelle, die einen Floating-Gate-Transistor (CFGT) enthält, in einer Folge von Programmierzyklen, die jeweils einen Schritt der Prüfung des Zustandes der Speicherzelle umfassen, gefolgt vom Anlegen eines Impulses einer Programmierspannung (Vpp) an die Speicherzelle, wenn der Prüfungsschritt zeigt, dass die Zelle sich nicht im programmierten Zustand befindet,

wobei der Prüfungsschritt ein erstes Lesen der Speicherzelle durch Anlegen einer ersten Lesespannung (Vy1), die höher ist, als eine Bezugsschwellenspannung (VTref), an ein Steuergitter der Speicherzelle umfasst, wobei die Speicherzelle als dem ersten Lesen zufolge nicht im programmierten Zustand befindlich angesehen wird, wenn ein erster Lesestrom (I3), der die Speicherzelle durchquert, größer ist, als ein erster Schwellenwert (Iref1),

**dadurch gekennzeichnet, dass** der Schritt der Prüfung der Speicherzelle ein zweites Lesen der Speicherzelle durch Anlegen einer zweiten Lesespannung (Vy2), die kleiner ist oder gleich der Bezugsschwellenspannung (VTref), an ihr Steuergitter umfasst, wobei die Speicherzelle als dem zweiten Lesen nach nicht im programmierten Zustand befindlich angesehen wird, wenn ein zweiter Lesestrom (I3'), der die Speicherzelle durchquert, größer ist, als ein zweiter Schwellenwert (Iref2), und in dem Programmierspannungsimpulse an die Speicherzelle angelegt werden, solange diese mindestens nach einem der beiden Lesevorgänge als nicht im programmierten Zustand befindlich angesehen wird, ohne eine Anzahl an Programmierimpulsen zu überschreiten, die einen Defekt der Speicherzelle bedeuten würde.

2. Verfahren nach Patentanspruch 1, in dem der zweite Schwellenwert (Iref2) gleich Null oder klein ist und in der Größenordnung einiger hundert oder tausend Nanoampere liegt.

3. Verfahren nach einem der Patentansprüche 1 und 2, in dem das Lesen des Prüfungsschrittes durch Vergleich des Stromes (I3), der die Speicherzelle durchquert, mit einem Bezugsstrom (Iref1) erfolgt, der den ersten Schwellenwert bildet, der eine Bezugsspeicherzelle (RFGT) durchquert, die eine nicht verschlechterte Transkonduktanzkurve aufweist und deren Schwellenspannung die Bezugsschwellenspannung (VTref) darstellt.

4. Verfahren nach Patentanspruch 3, in dem ein Offsetstrom, der den zweiten Schwellenwert (Iref2) bildet, parallel zu der Bezugsspeicherzelle (RFGT) eingeleitet wird, um den zweiten Lesevorgang auszuführen.

5. Verfahren nach einem der Patentansprüche 1 bis 4, die folgenden Schritte umfassend:

   - zum Abschluss des ersten Lesevorganges des Prüfungsschrittes Bereitstellung eines ersten Bit (Brk1), das den Zustand programmiert oder gelöscht der Speicherzelle dem ersten Lesen zufolge angibt,
   - zum Abschluss des zweiten Lesevorganges des Prüfungsschrittes Bereitstellung eines zweiten Bits (Brk2), das den Zustand programmiert oder gelöscht der Speicherzelle dem zweiten Lesen zufolge angibt,
   - Berechnung eines Doppellesebits (Bdrk) durch logische Verknüpfung des ersten und des zweiten Bits, und
   - Anlegen eines Programmierungsspannungsimpulses an die Speicherzelle, wenn das Doppellesebit (Bdrk) einen bestimmten Wahrheitswert hat.

6. Verfahren nach Patentanspruch 5, einen Schritt zur Speicherung des ersten Bits (Brk1) umfassend, einen Schritt zur Speicherung des zweiten Bits (Brk2) und einen Schritt des Anlegens des ersten und des zweiten Bits an eine logische Schaltung, um das Doppellesebit (Bdrk) zu erzeugen.

7. Verfahren nach den Patentansprüchen 5 und 6, die folgenden Schritte umfassend:

   - Bereitstellung von Programmierspannungsimpulsen (Vpp),
   - Vergleich eines in der Speicherzelle zu speichernden Bits (Bpk) mit dem Doppellesebit (Bdrk),
   - Erstellung eines Steuersignals (DTOKk), das einen bestimmten Wert aufweist, der das Anlegen der Programmierspannungsimpulse an die Speicherzelle verhindert, wenn das Doppellesebit (Bdrk) einen Wahrheitswert aufweist, der das Inverse des bestimmten Wertes ist, oder wenn das zu speichernde Bit einen Löschwahrheitswert aufweist.

8. Verfahren zur gemeinsamen Programmierung mehrerer Speicherzellen, **dadurch gekennzeichnet, dass** jede Speicherzelle **dadurch** programmiert wird, dass auf jede Speicherzelle einzeln das Programmierverfahren nach einem der Patentansprüche 1 bis 7 angewandt wird, wobei die Anzahl an Programmierspannungsimpulsen (Vpp), die jede Speicherzelle empfangen kann, je nach dem eventuellen Verschlechterungsgrad der Transduktanzkurve jeder Speicherzelle verschieden sein kann.

9. Speicher, Speicherzellen umfassend, die jeweils einen Floating-Gate-Transistor (CFGT) umfassen, eine Programmierschaltung (PCTk) und eine Leseschaltung (RCTk, SA), die derart angeordnet sind, dass sie auf eine zu programmierende Speicherzelle (CFGT) eine Reihe von Programmierzyklen anwenden, die jeweils einen Schritt der Prüfung der Speicherzelle umfassen, gefolgt vom Anlegen eines Programmierspannungsimpulses (Vpp) an die Speicherzelle, wenn der Prüfungsschritt zeigt, dass die Zelle sich nicht im programmierten Zustand befindet, wobei die Leseschaltung (RCTk, SA) derart angeordnet ist, dass sie in jedem Prüfungsschritt ein erstes Lesen der Speicherzelle durch Anlegen einer ersten Lesespannung (Vy1), die höher ist, als eine Bezugsschwellenspannung (VTref), an ein Steuergitter der Speicherzelle umfasst, und das Erstellen eines ersten Bits (Brk1) mit einem ersten bestimmten Wahrheitswert, wenn ein erster Lesestrom (13), der die Speicherzelle durchquert, größer ist, als ein erster Schwellenwert (Iref1),

**dadurch gekennzeichnet, dass** die Leseschaltung (RCTk, SA) derart angeordnet ist, dass sie in jedem Prüfungsschritt ein zweites Lesen der Speicherzelle durch Anlegen einer zweiten Lesespannung (Vy2), die kleiner ist oder gleich der Bezugsschwellenspannung (VTref), an ihr Steuergitter umfasst, und das Erstellen eines zweiten Bits (Brk2) mit einem zweiten bestimmten Wahrheitswert, wenn ein zweiter Lesestrom (I3'), der die Speicherzelle durchquert, größer ist, als ein zweiter Schwellenwert (Iref2), wobei die Programmierschaltung (PCTk) dafür eingerichtet ist, Programmierspannungsimpulse (Vpp) an die Speicherzelle anzulegen, solange das erste Bit (Brk1) den ersten Wahrheitswert aufweist oder das zweite Bit (Brk2) den zweiten Wahrheitswert aufweist, ohne eine Anzahl an Programmierimpulsen zu überschreiten, die eine Beschädigung der Speicherzelle bedeuten würde.

10. Speicher nach Patentanspruch 9, in dem der zweite Schwellenwert (Iref2) gleich Null oder klein ist und in der Größenordnung einiger hundert oder tausend Nanoampere liegt.

11. Speicher nach einem der Patentansprüche 9 und 10, in dem die Leseschaltung (RCTk) einen Leseverstärker (SA) umfasst, der eine Bezugsspeicherzelle (RFGT) aufweist, die eine nicht verschlechterte Transkonduktanzkurve (Cref) aufweist und deren Schwellenspannung die Bezugsschwellenspannung (VTref) bildet, und Mittel zum Vergleich des ersten Lesestromes (I3), der die zu lesende Speicherzelle (CFGT) durchquert, mit einem Bezugsstrom (Iref1), der die Bezugsspeicherzelle durchquert und den ersten Schwellenwert bildet.

12. Speicher nach Patentanspruch 11, in dem der Leseverstärker (SA) einen Erzeuger (IGEN) eines Offsetstromes (Iref2) umfasst, der parallel zur Bezugsspeicherzelle angeordnet ist, wobei der Offsetstrom den zweiten Schwellenwert bildet.

13. Speicher nach einem der Patentansprüche 9 bis 12, in dem die Leseschaltung Mittel umfasst, um ein Doppellesebit (Bdrk) durch logische Verknüpfung des ersten (Brk1) und des zweiten Bits (Brk2) zu erstellen.

14. Speicher nach Patentanspruch 13, in dem die Leseschaltung einen Reihenvergleicher (SCOMP) umfasst, der Mittel (DL11) zur Speicherung des ersten Bits (Brk1) aufweist, Mittel (DL12) zur Speicherung des zweiten Bits (Brk2) und eine logische Schaltung (G7) zur Verknüpfung des ersten und des zweiten Bits, die das Doppellesebit (Bdrk) erstellt.

15. Speicher nach einem der Patentansprüche 13 und 14, in dem die Programmierschaltung (PCTk) dafür eingerichtet ist, ein Steuersignal (DTOKk) auszugeben, das das Anlegen der Programmierspannungsimpulse an die Speicherzelle verhindert, wenn das Doppellesebit (Bdrk) einen bestimmten Wahrheitswert aufweist oder wenn ein in der Speicherzelle zu speicherndes Bit (Bpk) einen Löschwahrheitswert aufweist.

16. Speicher nach einem der Patentansprüche 9 bis 15, in dem der erste und der zweite Lesevorgang durch gepulste Steuersignale (VRFY1, VRFY2) synchronisiert sind, die verschobene Impulse aufweisen.

**Fig. 1A**

**Fig. 1B**

**Fig. 2**

**Fig. 3**

**Fig. 4**

**Fig. 5**

**Fig. 6**

Fig. 7

**Fig. 8**

Fig. 9A

Fig. 9B

Fig. 9C

Fig. 9D

Fig. 9E

Fig. 9F